# EUROPEAN PATENT APPLICATION

(11) **EP 3 876 280 A1**
(43) Date of publication of application: **08.09.2021**
(21) Application number: 20161170.4
(22) Date of filing: 05.03.2020
(51) Int. Cl.: H01L 27/146

(54) **PROCESS OF MANUFACTURING AN X-RAY IMAGING DEVICE AND TO AN X-RAY IMAGING DEVICE PRODUCED BY SUCH A PROCESS**

(71) Applicant: Nederlandse Organisatie voor toegepast- natuurwetenschappelijk Onderzoek TNO, 2595 DA 's-Gravenhage (NL)
(72) Inventor: Gelinck, Gerwin Hermanus, 2595 DA 's-Gravenhage (NL); Akkerman, Hylke Broer, 2595 DA s'-Gravenhage (NL); Van Breemen, Albert Jos Jan Marie, 2595 DA 's-Gravenhage (NL); Van der Steen, Jan-Laurens Pieter Jacobus, 2595 DA 's-Gravenhage (NL); Kronemeijer, Auke Jisk, 2595 DA s'-Gravenhage (NL)
(74) Representative: V.O.

(57) **Abstract**

An X-ray imaging device with an X-ray conversion area on a flexible circuit such as a Thin Film Transistor circuit with an array of detector cells is manufactured in a method comprising the steps of
- providing a flexible carrier layer on a substrate plate, with a first surface of the flexible carrier layer attached to the substrate plate and a second surface of the flexible carrier layer exposed, whereby the substrate plate hinders the flexible carrier layer from bending;
- creating an array of detector cells on a part of the second surface;
- mounting a peripheral circuit on the second surface outside said part, interconnected to the array of detector cells;
- attaching a further layer to the second surface, after or before mounting the peripheral circuit, the further layer comprising an X-ray conversion area at least over the array of detector cells, the further layer being attached to the flexible carrier layer beyond a first edge of the array of detector cells, and beyond the peripheral circuit, the further layer comprising a recess or and opening to accommodate the peripheral circuit;
- detaching the substrate plate from the flexible carrier layer before the end of manufacturing the X-ray imaging device.

## Description

### Field of the invention

The invention relates to a process of manufacturing an X-ray imaging device and to an X-ray imaging device produced by such a process.

### Background

X-ray imaging is conventionally performed by registering an effect produced by an X-ray conversion layer as a function of position. For example, when a scintillation layer is used as X-ray conversion layer, the cumulative intensity of the light produced by the scintillation layer is registered as a function of position. When an X-ray to charge X-ray conversion layer is used, cumulative charge produced by the layer is registered. The effect of the X-rays can be registered by means of an electro-optical detector array or charge detector array on a glass plate or other substrate, with the X-ray conversion layer on top of the electro-optical detector array or charge detector array, deposited by e.g. lamination using an adhesive, and peripheral electronic circuits on the substrate next to the X-ray conversion layer, e.g. integrated in an integrated circuit on the substrate.

Earlier X-ray imaging made use of a photographic film instead of an electro-optical detector array to register the image. The use of an electro-optical detector array has the obvious advantage that it does not require a development step of the photographic film and that the image is immediately available for electronic storage, display and processing. However, in other aspects the use of an electro-optical detector array on a glass plate is less convenient than a photographic film. For example, in medical applications it may be more cumbersome to place the device in the desired position relative to a patient because the glass plate is stiff and heavy.

In more complicated X-ray detection devices a plurality of X-ray conversion layers are stacked. Stacking may be useful to realize multi spectral X-ray detection for example. In stacked devices it is a problem that stacking of X-ray conversion layers can lead to damage to layers that include detectors.

### Summary

Among others, it is an object to provide for a way of manufacturing a more convenient X-ray imaging device. An optional further object is to reduce the risk of damage when stacking is used.

A method of manufacturing an X-ray imaging device is provided, which comprises
- providing a flexible carrier layer on a substrate plate, with a first surface of the flexible carrier layer attached to the substrate plate and a second surface of the flexible carrier layer exposed, whereby the substrate plate hinders the flexible carrier layer from bending;
- creating an array of detector cells on a part of the second surface;
- mounting a peripheral circuit on the second surface outside said part, interconnected to the array of detector cells;
- attaching a further layer to the second surface (the steps of mounting peripheral circuit on the second surface may be performed before or after attaching the further layer to the second surface, or these steps may be performed simultaneously), the further layer comprising an X-ray conversion area at least over the array of detector cells, the further layer being attached to the flexible carrier layer beyond a first edge of the array of detector cells, and beyond the peripheral circuit, the further layer comprising a recess or and opening to accommodate the peripheral circuit;
- detaching the substrate plate from the flexible carrier layer before the end of manufacturing the X-ray imaging device.

The substrate plate may be a glass plate for example. The further layer may consist entirely of the X-ray conversion area, or comprise another material of similar stiffness laterally adjacent to the area. Problems due to differences in stiffness of the flexible carrier layer and the layer that comprises the X-ray conversion area, such as a scintillator layer or an X-ray to charge conversion layer can be avoided and a flexible X-ray imaging device is obtained that can be fitted into place for use.

Preferably, a ratio of the stiffness of the flexible carrier layer and the stiffness of the further layer has a value so that the stiffness of the X-ray imaging device is substantially determined by the stiffness of the further layer (substantially means e.g. that the X-ray imaging device is less than 101% of the stiffness of the further layer on its own). The stiffness of the further layer is mainly determined by the stiffness of the X-ray conversion layer. This reduces the risk of damage to the array of detector cells sand allows bending the X-ray imaging device into place e.g. for medical use.

In an embodiment, the further layer extends over the entirety of the flexible carrier layer. The further layer may even extend beyond the flexible carrier layer. This prevents stress due to free bending of the flexible layer.

In an embodiment, the further layer consists of the X-ray conversion layer. In another embodiment, the further layer comprises a layer part that is not an X-ray conversion layer outside the area above the array of detector cells. The X-ray conversion layer covers the array of detector cells and is attached to the array of detector cells. The X-ray conversion layer and the layer part may be laterally adjacent to each other in the sense that, together, they form a layer wherein the X-ray conversion layer and the layer part cover different areas below that layer. In the embodiment with a layer part that is not of the material of the X-ray conversion layer, the layer part preferably surrounds the X-ray conversion layer in all lateral directions. Preferably the layer part and the X-ray conversion layer have similar stiffness (e.g. not different by more than a factor two).The layer part may be laminated to the substrate with an adhesive.

An X-ray imaging device manufactured using the steps of any of the preceding claims comprising a flexible carrier layer and a further layer comprising an X-ray conversion layer, wherein the stiffness of the X-ray imaging device is substantially determined by the flexible carrier layer and the X-ray conversion layer, with an array of detector cells and a peripheral circuit electrically interconnected to the detector cells on the flexible carrier layer, wherein the further layer is attached to the flexible carrier layer beyond first and second, mutually opposite edges of the array of detector cells, and beyond the peripheral circuit, the further layer comprising a recess or and opening to accommodate the peripheral circuit.

### Brief description of the drawing

These and other objects and advantageous aspects will become apparent from a description of exemplary embodiments with reference to the following figures.
Figures 1, 1a shows steps of a process of manufacturing an X-ray imaging device
Figures 2a-f show cross-sections of intermediate product formed during the process
Figure 3 shows a top view of the X-ray imaging device
Figure 4 shows an embodiment of an X-ray imaging device with a two-part layer
Figures 4a, b illustrate manufacture of a device with a two part layer
Figures 5, 6 show stacks of detection devices

### Detailed description of exemplary embodiments

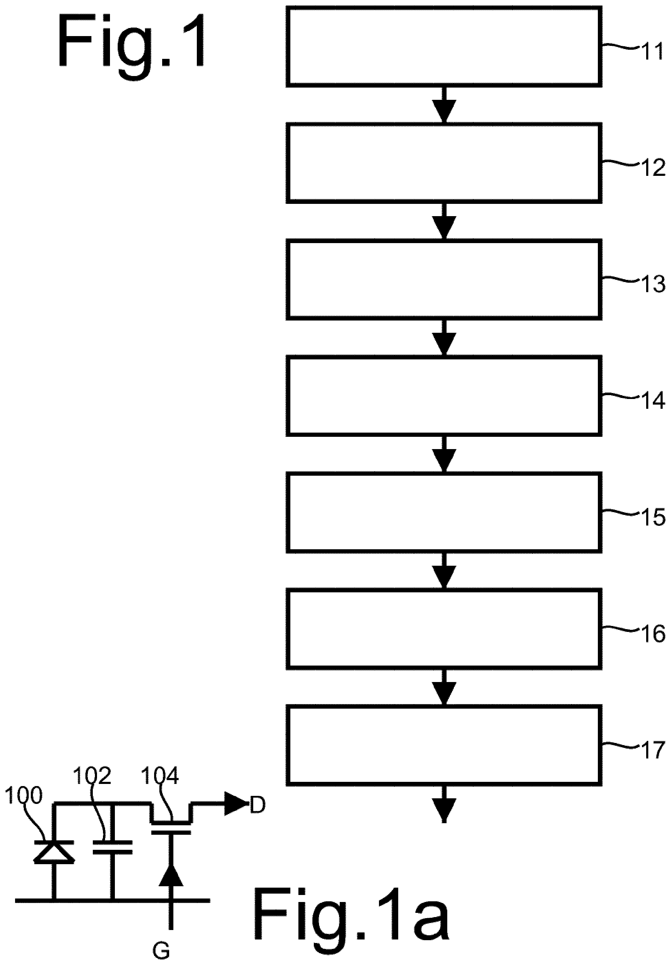

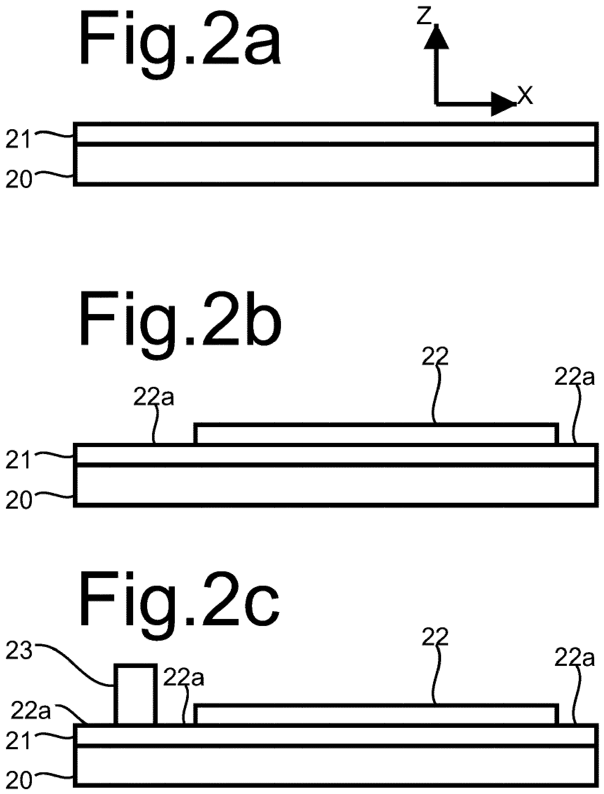

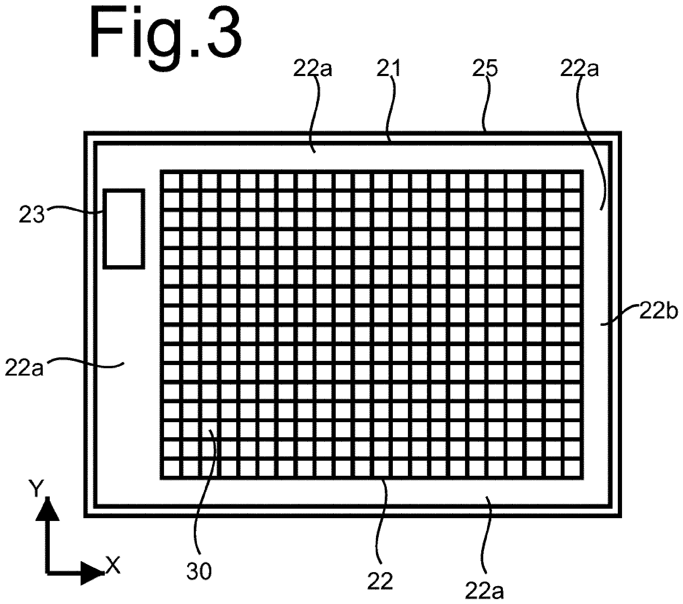

Figure 1 shows steps of a process of manufacturing an X-ray imaging device that uses a scintillator based X-ray conversion or X-ray to charge conversion. Figures 2a-d show cross-sections of intermediate products formed during the process (with a height scale exaggerated with respect to the width scale and components not to scale). Figure 3 shows a view of the device after the final step of the process of figure 1, also not to scale.

In a first step 11 a rigid substrate plate such as a glass plate 20 is provided. In a second step 12 a flexible carrier layer 21 is laminated to or deposited on glass plate 20, as shown in figure 2a. In exemplary embodiments, carrier layer 21 may be Poly Imide (PI), Poly Ethylene Naphthalene (PEN), Poly Ethylene Terephthalate (PET). In exemplary embodiments, carrier layer 21 may have a thickness in a range of 10-125 micrometer. In such embodiments, typical stiffness moduli of 8.5 GPa can be realized for PI, 5 GPa for PEN and 4 GPa for PET.

A layer of a release agent (not shown) may be provided between flexible carrier layer 21 and glass plate 20. By way of reference a direction along flexible carrier layer 21 is indicated as the x direction and the direction perpendicular to flexible carrier layer 21 is indicated as the z-direction.

A third step 13 stands for a number of sub-steps wherein an array of detector cells 22 and its associated wiring is created on flexible carrier layer 21. Figure 1a shows a schematic of an exemplary electro-optical detector cell 22, comprising a photo diode 100, a capacitor 102 and a TFT access transistor 104. Photo diode 100 and capacitor 102 may be formed by electrodes of electrically conductive material with a semi-conductor layer in between. One electrode (e.g. on top of the cell) is an optically transparent electrode coupled to ground (e.g. a ground plane or a plurality of parallel ground strips) and the other electrode forms a capacitor plate that is coupled to a data line D via the channel of TFT access transistor 104. The optically transparent top electrode and the semi-conductor layer may extend over a plurality of detector cells.

The gate of TFT access transistor 104 is coupled to a gate line G. In operation of detector cell 22, photo diode 100 generates electric current in response to incoming light, which charges capacitor 102. In response to a selection signal on gate line G the charge is transferred to the date line.

When an X-ray to charge conversion based imaging device is manufactured, photo diode 100 may be omitted and an electrode may be provided on top of the X-ray to charge conversion layer instead of on the semi-conductor layer that forms the photo diode in the electro -optic embodiment. Thus capacitor 102 is formed between the latter electrode and the electrode that is connected to the channel of transistor 104, with the X-ray to charge conversion layer in between. In this embodiment the detector cells 22 on flexible layer 21 comprise the transistor 104 and the plate electrode that is connected to transistor 104, but not the X-ray to charge conversion layer and the electrode on top of the X-ray to charge conversion layer.

Sub-steps for creating an array of detector cells 22 and its associated wiring are known per se, e.g. from G. Gelinck et al "X-ray detector-on-plastic with high sensitivity using low cost, solution-processed organic photodiodes". IEEE Transactions on Electron Devices, 63(1), 197-204 (2016). A.R. Cowen, S.M. Kengyelics, A.G. Davies, Clinical Radiology (2008) 63, 487e498 also describe such detectors. TFT transistors can be realized on a flexible layer, which makes it possible for the array of detector cells to conform to bending of the X-ray conversion layer and keeps the detector cell array very thin. Preferably, the flexible layer 21 on which the array of detector cells 22 is located does not extend laterally beyond the X-ray conversion layer. This reduces the risk of damage.

Figure 2b shows the array of detector cells 22 on top of flexible carrier layer 21. It should be noted that the width of array of detector cells 22 is smaller than that of flexible carrier layer 21, so that peripheral areas 22a are left on flexible carrier layer 21 next to array of detector cells 22. Preferably, the length of array of detector cells 22 (perpendicular to the plane of the drawing) is also smaller than the length of flexible carrier layer 21, so that a peripheral area 22a is present on flexible carrier layer 21 surrounding array of detector cells 22. The array can also be seen in figure 3 in an x-y plane parallel to flexible carrier layer 21. The number of rows and columns of detector cell areas 30 in the array is merely an example: in practice more rows and columns will usually be used.

In a fourth step 14 a peripheral circuit 23 is placed on flexible carrier layer 21 next to array of detector cells 22 on the peripheral area on flexible carrier layer 21, in electrical connection with wiring that connects peripheral circuit 23 to detector cells 22. This is illustrated by figure 2c, which shows a peripheral circuit 23 comprising a single circuit component in the form of an integrated circuit on flexible carrier layer 21, but it should be realized that more discrete circuit components such as resistors etc. may also be present on flexible carrier layer 21, or that more than one integrated circuit may be used.

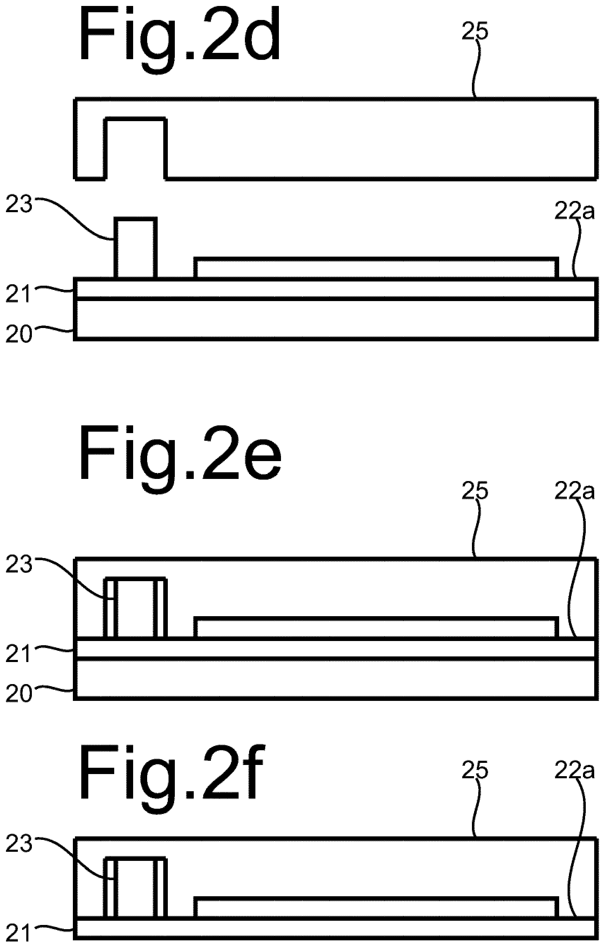

In a fifth step 15 an X-ray conversion layer 25 is provided, having a size that is sufficient to cover array of detector cells 22 and a perimeter area adjacent to the array of detector cells 22 as illustrated in figure 2d. In a scintillator based X-ray imaging device any scintillator may be used, for example Thallium doped cesium Iodide (CsI(Tl)) and Gadolinium oxy-sulfide (GOS) for indirect charging.

When an X-ray to charge X-ray conversion based imaging device is manufactured, an X-ray to charge conversion layer is provided and an X-ray transparent top electrode is provided on top of X-ray to charge conversion layer. Suitable X-ray to charge conversion materials are known per se. For example amorphous selenium (a-Se) or a perovskite may be used, such as Methyl Ammonium Lead Iodide (MAPI) direct conversion layer: (CH3)3NPbI3) and Cesium Lead Bromide (CsPbBr3).

In an embodiment, the layer thickness of the X-ray conversion layer 25 may be in a range of 100 micrometer to 1000 micrometer.

In a sixth step 16, X-ray conversion layer 25 is laminated onto detector cells 22 and peripheral area(s) 22b, as illustrated in figure 2e. X-ray conversion layer 25 may be laminated onto detector cells 22 for example by means of an adhesive. In an embodiment, fourth step 14 may be performed after sixth step 16, so that the peripheral circuit is mounted on the second surface after attaching X-ray conversion layer 25 to the second surface. In another embodiment, fourth step 14 and sixth step 16, may be performed simultaneously, so that the peripheral circuit is mounted on the second surface when X-ray conversion layer 25 is attached to the second surface.

In the embodiment of the X-ray to charge X-ray conversion based imaging device, the capacitor 102 of the detector cell of figure 1a is replaced by a capacitor formed between the plate electrode of the detector cell and the X-ray transparent top electrode, with the X-ray to charge conversion layer in between.

Instead of providing a previously prepared X-ray conversion layer 25 and laminating it onto detector cells 22 and peripheral area(s) 22a, by means of fifth and sixth steps 15, 16, X-ray conversion layer 25 may be deposited on detector cells 22 and peripheral area(s) 22a, e.g. by means of a printing process or other material deposition process.

In a seventh step 17, glass plate 20 is delaminated from flexible carrier layer 21, leaving a finished device, without glass plate 20 as illustrated in figure 2f. Herein, X-ray conversion layer 25 is thicker and less flexible than flexible carrier layer 21 per se and the combination of flexible carrier layer 21 and the array of detector cells 22. For the sake of illustration, figure 3 shows an embodiment wherein the lateral extent flexible carrier layer 21 is smaller than X-ray conversion layer 25, but in other embodiments flexible carrier layer 21 and X-ray conversion layer 25 may be co-terminous. The delamination can be realized for example by means of laser release (see R. Delmdahl et al. "Large-area laser-lift-off processing in microelectronics", in Physics Procedia 2013. 41: 241 - 248) or by mechanical release. When a release agent has been added between flexible carrier layer 21 and glass plate 20 in first step 11, this facilitates mechanical release. However, for laser release (e.g. of Poly Imide) no release agent may be needed.

Preferably, a ratio of the stiffness of the flexible carrier layer 21 and the stiffness of the X-ray conversion layer 25, or further layer of which it is part, has a value so that the stiffness of the X-ray imaging device is substantially determined by the stiffness of the further layer. For example, the ratio may have a value so that the stiffness of the X-ray imaging device with the flexible layer and the X-ray conversion layer 25, or further layer, is not more than ten percent higher than that of the X-ray conversion layer 25, or further layer. This does not depend on how the stiffness values are determined, as long as they are determined in the same way. For example the stiffness of each layer can be determined from the degree of bending of the layer when one end of the layer is fixed and a force perpendicular to the layer is exerted at the opposite end. The stiffness of the scintillation layer or further layer is mainly determined by the thickness of the scintillation layer. This allows for deformation of the X-ray imaging device to fit the device into place during use.

In operation during X-ray detection, X-ray conversion layer 25 directly or indirectly charges the capacitors that includes the plate electrodes in the cells of the array detector cells 22. In a first embodiment, direct charging may be used, wherein the X-ray to charge conversion layer directly generates an electric current to charge the plate electrode in response to X-rays. In a second embodiment indirect charging is used wherein the photo diode 100 in the detector cells act as photo-detector charges the plate electrode of the detector cell that generate electric current in response to light produced by the scintillator layer 25 in response to X-rays.

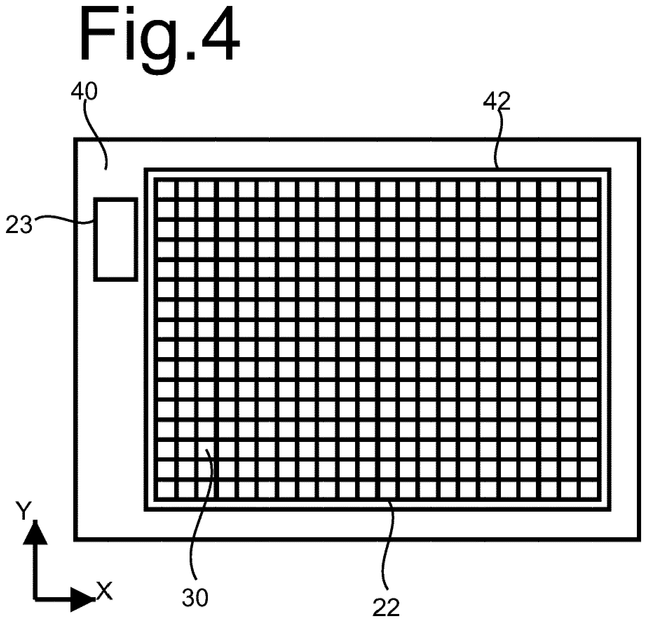

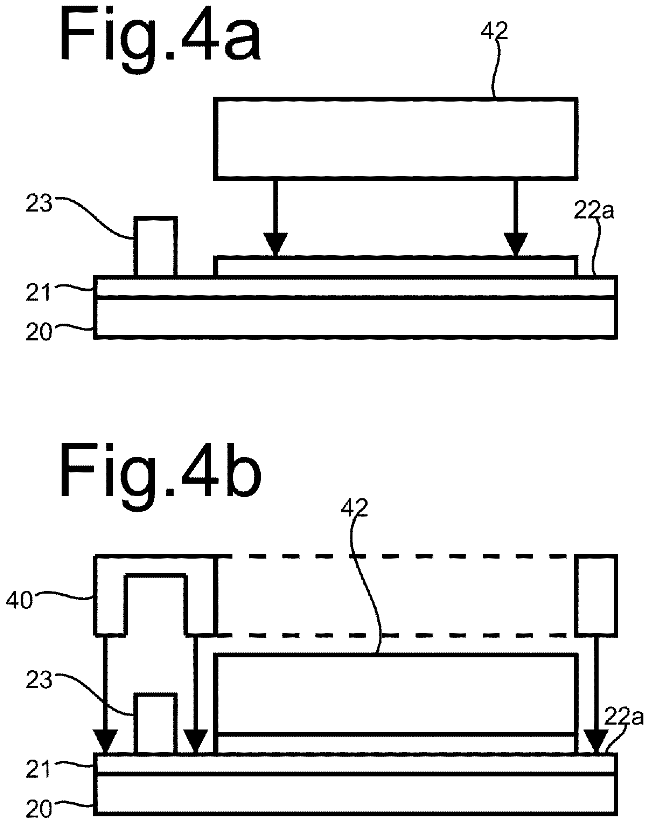

Figure 4 shows an embodiment of a device with stacked X-ray conversion layers. In the illustrated embodiments a two-part layer 40, 42 is used instead of a single X-ray conversion layer 25. Herein a first layer part 40 is provided on the flexible carrier layer around array of detector cells 22 and a second layer part 42 is provided on array of detector cells 22, fitting within an opening in first layer part 40 above array of detector cells 22. First layer part 40 need not be an X-ray conversion layer. This cost can be reduced by reducing the area of the device that is covered by the X-ray conversion layer.

First layer part 40 and second layer part 42 may be laminated onto the device together at the same time or one after the other in separate steps. Figures 4a and 4b illustrates an embodiment wherein second layer part 42 is applied first in a step similar to fifth step 15, covering only array of detector cells 22 or at least not all of flexible carrier layer 21 as shown in figure 4a. Subsequently, as shown in figure 4b second layer part 42 is applied in a step similar to fifth step 15, covering the part of flexible carrier layer 21 that is not covered by a second layer part 42. Preferably, the flexible layer 21 on which the array of detector cells 22 is located does not extend laterally beyond the layer formed by the combination of the X-ray conversion layer part 40 and 42. This reduces the risk of damage.

As shown, a cavity in first layer part 40 is provided over peripheral circuit 23. Instead first layer part 40 may comprise an opening over peripheral circuit 23. In an embodiment, the cavity or opening may at least partly be filled with X-ray absorbing or reflecting material to shield peripheral circuit 23 against incoming X-rays.

Devices of the type described in the preceding may be stacked, for example to provide for simultaneous imaging of X-rays in different wavelength bands. When such embodiments are used, the stack will be exposed to X-rays from one surface side and the X-rays will be converted as they travel through the stack from that surface.

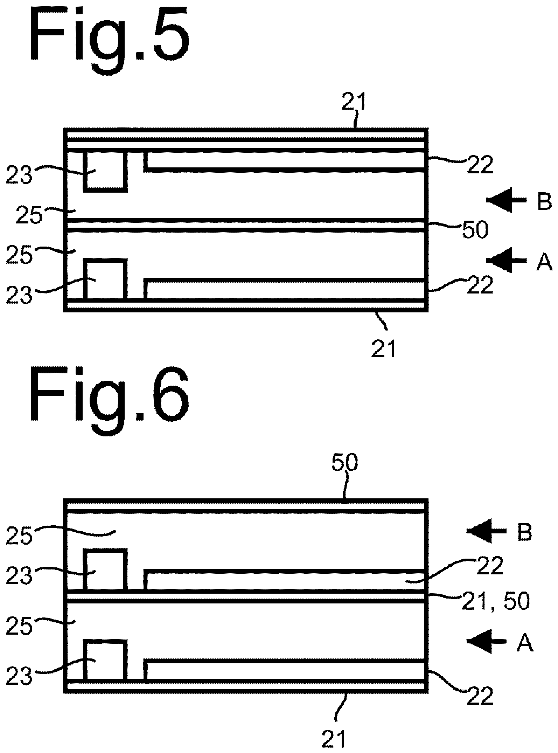

Figure 5 shows an embodiment of an assembly of two detection devices A, B on top of each other, each with an X-ray conversion layer 25 and an array of detector cells 22 (vertical and horizontal scale not the same). In this embodiment array and the peripheral circuit 23 are located on opposite surfaces of the stack of X-ray conversion layers, with the X-ray conversion layers 25 in between. An X-ray transparent conductor layer 50 or stack of layers 50 is located in between the X-ray conversion layers 25 of the different devices A, B. When the stack is used for imaging of X-rays in different wavelength bands, X-ray layers of different material composition may be used in the different layers, to provide for conversion of X-rays from different wavelength bands, or to block transmission of X-rays within a band from reaching the other X-ray conversion layer. The arrangement of figure 5 has the advantage that the arrays of detector cells of each device is as far as possible from the X-ray conversion layer of the other device, which reduces the risk of cross-talk.

Such a stack of devices A, B may be manufactured for example by manufacturing both devices A, B as described in the preceding. In this process, before providing the X-ray conversion layer 25 on the flexible layer 21 and array of detector cells 22 of one of the devices A, B, the X-ray conversion layer 25 of that one of the devices A, B is provided on the X-ray conversion layer 25 of the other device B,A, if need be with one or more conductor layers 50 in between. In an embodiment, the X-ray conversion layers 25 of both devices A,B may be created as a single X-ray conversion layer 25, of the same composition, or with a composition that varies with height. The composition variation with height may be used to cause detection of conversion in different X-ray wavelength bands in the different devices A,B.

Alternatively, the X-ray conversion layers 25 with conductive layers 50 on top may be attached to each other after they have been provided on the flexible layers. In this case the substrates may be detached before the X-ray conversion layers 25 are attached to each other, or after both have been detached or between detachment of the substrates from the devices A, B. Detachment of at least one substrate after attaching conversion layers 25 to each other prevents bending during attachment attaching conversion layers 25 to each other.

Figure 6 shows an embodiment of the stack wherein a flexible carrier layer 21 with the array of detector cells 22 of the peripheral circuit 23 are both below the X-ray conversion layer of their device A, B. To manufacture this stack the substrate of one device B must be detached before that device can be provided on top the other.

In another embodiment the flexible layers of the stacked devices A, B may be attached back to back, so that the arrays of detector cells22 are located between the X-ray conversion circuit. This requires detachment of the substrates from both devices A, B before assembly of the stack. Moreover, when scintillation layers are used as X-ray conversion layers, a layer that is optically not transparent and X-ray transparent.

Although examples of a two device stack have been shown, it should be appreciated that more than two devices may be stacked. By using X-ray conversion layers that extend over the entire array of detector cells of the devices the risk of damage during assembly due to bending of the part of flexible layer 21 on which the detector cells are located is reduced. Preferably, flexible layers 21 in the stack do not extend laterally beyond the X-ray conversion layers, or the layers that contains the X-ray conversion layer. This reduces the risk of damage in the stack.

## Claims

1. A method of manufacturing an X-ray imaging device comprising
- providing a flexible carrier layer on a substrate plate, with a first surface of the flexible carrier layer attached to the substrate plate and a second surface of the flexible carrier layer exposed, whereby the substrate plate hinders the flexible carrier layer from bending;
- creating an array of detector cells on a part of the second surface;
- mounting a peripheral circuit on the second surface outside said part, interconnected to the array of detector cells;
- attaching a further layer to the second surface, the further layer comprising an X-ray conversion area at least over the array of detector cells, the further layer being attached to the flexible carrier layer beyond a first edge of the array of detector cells, and beyond the peripheral circuit, the further layer comprising a recess or and opening to accommodate the peripheral circuit;
- detaching the substrate plate from the flexible carrier layer before the end of manufacturing the X-ray imaging device.

2. A method of manufacturing an X-ray imaging device according to claim 1, wherein a ratio of the stiffness of the flexible carrier layer and the stiffness of the further layer has a value so that the stiffness of the X-ray imaging device is substantially determined by the stiffness of the further layer.

3. The method of manufacturing an X-ray imaging device according to any of the preceding claims, wherein the further layer extends at least over the entirety of the flexible carrier layer.

4. The method of manufacturing an X-ray imaging device according to any of the preceding claims, wherein the entire further layer forms the X-ray conversion area.

5. The method of manufacturing an X-ray imaging device according to any of the preceding claims, wherein the X-ray conversion area covers the array of detector cells and is attached to the array of detector cells as part of the further layer, the further layer further comprising a layer part that is not an X-ray conversion layer, laterally adjacent the X-ray conversion layer attached to the flexible carrier layer outside the array of detector cells.

6. A method of manufacturing an X-ray imaging device according to any of the preceding claims, wherein the substrate plate is a glass plate.

7. A method of manufacturing an X-ray imaging device according to any of the preceding claims wherein the X-ray conversion area comprises a scintillation material over the full thickness of the further layer.

8. A method of manufacturing an X-ray imaging device according to any of claims 1-6, wherein the X-ray conversion area comprises an X-ray to charge conversion material over the full thickness of the further layer.

9. A method of manufacturing a stack of X-ray imaging devices, both according to any of the preceding claims.

10. A method according to claim 9, wherein the X-ray conversion layers of the devices in the stack are attached to each other, optionally via one or more intermediate electrical conductor layers, or formed together, with the flexible layers of the stacked devices on opposite surfaces of the combination of the attached X-ray conversion layers.

11. An X-ray imaging device comprising a plurality of layers, the layers comprising
- a first layer that substantially determines the stiffness of the device, at least part of the first layer forming an X-ray conversion area;
- a flexible carrier layer attached to the first layer;
- an array of detector cells on a part of the flexible carrier layer, between the flexible carrier layer and the X-ray conversion area;
- a peripheral circuit on the surface of the flexible carrier layer outside said part of the flexible carrier layer, interconnected to the array of detector cells, extending into a recess or opening in the first layer, wherein the first layer is attached to the flexible carrier layer beyond a first edge of the array of detector cells, and beyond the peripheral circuit.

12. A stack of X-ray imaging devices, comprising a first and second X-ray imaging device according to claim 11.

13. A stack method according to claim 9, wherein the X-ray conversion layers of the first and second device in the stack are attached to each other, optionally via one or more intermediate electrical conductor layers, or of an integral body, with the flexible layers of the stacked devices on opposite surfaces of the combination of the attached X-ray conversion layers.
